(19) **Europäisches Patentamt European Patent Office Office européen des brevets**

(11) **EP 2 507 912 B1**

(12) **FASCICULE DE BREVET EUROPEEN**

(45) Date de publication et mention de la délivrance du brevet:
**16.10.2013 Bulletin 2013/42**

(21) Numéro de dépôt: **10807597.9**

(22) Date de dépôt: **24.11.2010**

(51) Int Cl.:
*H03K 5/08* (2006.01)     *H03K 5/1534* (2006.01)
*H03K 17/0412* (2006.01)     *H04B 10/50* (2013.01)

(86) Numéro de dépôt international:
**PCT/FR2010/052514**

(87) Numéro de publication internationale:
**WO 2011/067514 (09.06.2011 Gazette 2011/23)**

(54) **CIRCUIT À COMPOSANTS PASSIFS DE PILOTAGE ULTRARAPIDE D'UN DISPOSITIF OPTOÉLECTRONIQUE**

SCHALTUNG MIT PASSIVEN KOMPONENTEN FÜR ULTRASCHNELLE STEUERUNG EINES OPTOELEKTRONISCHEN VORRICHTUNG

CIRCUIT WITH PASSIVE COMPONENTS FOR THE ULTRA-QUICK CONTROL OF AN OPTOELECTRONIC DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.12.2009 FR 0905792**

(43) Date de publication de la demande:
**10.10.2012 Bulletin 2012/41**

(73) Titulaires:
- **Institut National des Sciences Appliquées de Toulouse**
  **31077 Toulouse Cedex 4 (FR)**
- **Centre National de la Recherche Scientifique (C.N.R.S.)**
  **75794 Paris Cedex 16 (FR)**

(72) Inventeurs:
- **BINH, Phi Hoa**
  **10000 (VN)**
- **MARIE, Xavier**
  **F-31320 Pechabou (FR)**
- **RENUCCI, Pierre**
  **F-31320 Castanet Tolosan (FR)**
- **TRUONG, Viet Giang**
  **F-31400 Toulouse (FR)**

(74) Mandataire: **Cabinet BARRE LAFORGUE & associés**
**35, rue Lancefoc**
**31000 Toulouse (FR)**

(56) Documents cités:
**DE-A1- 3 502 325     US-A- 5 329 210**

**Description**

L'invention concerne un circuit de pilotage ultrarapide d'un dispositif optoélectronique, ce dernier comprenant au moins une diode optoélectronique (LED(s), diode(s) laser à semi-conducteurs).

Le pilotage ultrarapide de telles diodes optoélectroniques est important dans le domaine des télécommunications optiques à haut débit (par exemple dans le cadre du projet de réseau Internet FTTH à fibres optiques, des applications FS0 (« Free Space Optical Communication ») dans lesquelles des faisceaux lumineux sont émis à partir du plafond d'un local pour remplacer les connexions WIFI, ou des applications de connexions optiques entre composants sur cartes électroniques et/ou entre cartes électroniques et/ou à titre de bus dans les ordinateurs). Jusqu'à maintenant, les sources lumineuses utilisées dans de telles applications sont des diodes laser à semi-conducteurs nécessitant des dispositifs coûteux de contrôle en longueur d'onde et de stabilisation de température. Les diodes électroluminescentes (LEDs) du commerce sont plus économiques que les diodes laser, mais présentent une fréquence de modulation limitée, typiquement inférieure ou de l'ordre de 150 MHz, insuffisante pour atteindre les débits actuellement recherchés supérieurs à plusieurs centaines de mégabits par seconde, typiquement de l'ordre de plusieurs gigabits par seconde. En effet, pour des télécommunications optiques à de tels débits, il est nécessaire de pouvoir piloter les sources lumineuses à des fréquences supérieures à 1 GHz, voire de l'ordre de plusieurs dizaines de gigahertz.

Par ailleurs, le pilotage ultrarapide de diodes optoélectroniques est également nécessaire dans les équipements scientifiques (notamment pour la détection optique de molécules, les techniques de spectroscopie en fluorescence...) qui nécessitent des sources de lumière produisant des impulsions courtes (quelques centaines de picosecondes), même si la fréquence de répétition peut être inférieure à 100 MHz.

Les circuits de pilotage connus de diodes optoélectroniques sont des systèmes complexes comprenant un circuit de mise en forme d'impulsions de commande incluant des composants actifs tels que des transistors bipolaires ou des circuits de type RC relativement peu performants et induisant des pertes (cf. par exemple EP 0470780 ; US 5329210 ; circuit intégré référence MC2042-4 (http://www.mindspeed.com) ; E.F. Schubert, N.E.J. Hunt, R.J. Malik, M.Micovic and D. L. Miller, Journal of Lightwave Technology, vol 14, N°7 (1996)). En outre, les dispositifs connus à base de composants actifs qui peuvent approcher des performances acceptables du point de vue de la durée des impulsions optiques émises délivrent une puissance optique relativement faible et sont très coûteux (typiquement plusieurs milliers d'euros).

Dans ce contexte, l'invention vise à proposer un circuit de pilotage ultrarapide d'un module optoélectronique qui simultanément soit de faible coût, simple et rapide, et permette notamment l'émission d'impulsions optiques de durée inférieure à 2000 ps et/ou une modulation large signal de fréquence supérieure à 500 MHz, avec une puissance pic supérieure à $20\mu$W, notamment de l'ordre de 50 $\mu$W pour une fréquence de 1 GHz.

Pour ce faire, l'invention concerne un circuit de pilotage ultrarapide d'un dispositif optoélectronique comprenant au moins une diode optoélectronique, caractérisé en ce qu'il comprend :

- un générateur de créneaux de tension présentant des fronts de durée inférieure à 400 ps,
- un circuit de mise en forme d'impulsions de commande du dispositif optoélectronique, ce circuit de mise en forme d'impulsions comportant :

    - une sortie adaptée pour être reliée au dispositif optoélectronique,
    - et une entrée reliée au générateur de créneaux de tension et recevant les créneaux de tension formés par ce dernier,
    - entre une borne de ladite entrée et une borne de ladite sortie reliée en série à une borne d'alimentation du dispositif optoélectronique, montées en parallèle l'une par rapport à l'autre :

        - une première branche formée d'un circuit redresseur passif à tension de seuil non nulle, en série dans la première branche et en sens direct par rapport à ladite borne d'alimentation du dispositif optoélectronique,
        - une deuxième branche capacitive -notamment exclusivement capacitive-.

Par « circuit redresseur passif » on désigne un circuit redresseur constitué exclusivement de composants électroniques passifs, et en particulier exempt de transistors (tels que MOSFET, IGBT ...). De façon totalement surprenante, il s'est avéré en effet qu'un tel circuit de mise en forme d'impulsions, malgré sa très grande simplicité, fournit des résultats étonnants et inexpliqués.

En particulier, avantageusement et selon l'invention, ledit circuit redresseur passif à tension de seuil non nulle (et donc ladite première branche) comprend au moins une diode en série dans ladite première branche -notamment est formé d'au moins une diode en série dans ladite première branche- et en sens direct par rapport à la borne d'alimentation du dispositif optoélectronique.

Plus particulièrement, avantageusement et selon l'invention, ledit circuit redresseur passif à tension de seuil non nulle présente une tension de seuil totale supérieure à 0,5V et une résistance dynamique inférieure à 50 $\Omega$.

Dans un premier mode de réalisation, avantageusement et selon l'invention, ledit circuit redresseur passif à tension de seuil non nulle (et donc ladite première branche) comprend au moins une diode Schottky. Plus particulièrement, il est formé d'au moins une diode Schottky -notamment d'une pluralité de diodes Schottky en série-. L'augmentation de la tension seuil totale cumulée des diodes Schottky dans la première branche permet d'augmenter la charge stockée dans la deuxième branche capacitive dans le cas d'un fonctionnement sous tension de polarisation. Néanmoins, cette augmentation implique une augmentation simultanée de la résistance dynamique de la première branche, au détriment de la valeur du courant de pilotage.

Avantageusement et selon l'invention, la première branche est formée de deux diodes Schottky en série. Cette valeur s'avère en effet constituer un compromis dans un grand nombre de situations, notamment pour le pilotage d'un dispositif optoélectronique constitué d'une diode LED du commerce.

En outre, avantageusement et selon l'invention, chaque diode Schottky présente une tension de seuil de l'ordre de 0,3 V à 0,35 V, une résistance dynamique de l'ordre de 6 $\Omega$, et une bande passante de l'ordre de 10 GHz.

Dans un autre mode de réalisation, avantageusement et selon l'invention, ledit circuit redresseur passif à tension de seuil non nulle (et donc ladite première branche) comprend au moins une diode PIN. Plus particulièrement, il est formé d'au moins une diode PIN, notamment d'une diode PIN unique, par exemple une diode PIN présentant une tension de seuil de l'ordre de 0.9V à 1V, une résistance dynamique de l'ordre de 0.5 $\Omega$ à 1 $\Omega$, et une bande passante de l'ordre de 1 GHz à 5 GHz.

En variante, ledit circuit redresseur passif à tension de seuil non nulle (et donc ladite première branche) peut être formée de plusieurs composants de nature distincte, par exemple une diode Schottky et une diode PIN en série.

Par ailleurs, avantageusement et selon l'invention, la capacité de la deuxième branche est comprise entre 0, 2 fois et 2 fois la capacité du dispositif optoélectronique sous tension nulle. La deuxième branche est exclusivement capacitive en ce sens qu'elle présente une valeur de résistance et d'inductance qui sont négligeables par rapport à la valeur de sa capacité entre ladite entrée et ladite borne de sortie. Il est à noter par ailleurs que cette capacité série dans la deuxième branche peut être formée par tout (s) composant (s) capacitif (s), notamment par un simple condensateur ou par des combinaisons de condensateurs.

Avantageusement et selon l'invention, la capacité de la deuxième branche est comprise entre 10 pF et 200 pF. Cette valeur est déterminée, notamment expérimentalement par des essais, en fonction du dispositif optoélectronique.

Par ailleurs, de préférence et notamment dans le cas où le dispositif optoélectronique est constitué de LED(s), le générateur de créneaux de tension est adapté pour produire des créneaux de tension d'amplitude crête comprise entre 0V et 4V de durée comprise entre 250ps et 4ns.

En outre, avantageusement et selon l'invention, le générateur de créneaux de tension est adapté pour fournir une tension Vc continue de polarisation de valeur inférieure à la tension de seuil totale de la première branche -notamment inférieure à la somme des tensions de seuil de la (des) diode(s) (Schottky et/ou PIN) de la première branche et de chaque diode optoélectronique du dispositif optoélectronique. Dans un mode de réalisation avantageux et selon l'invention le générateur de créneaux de tension est adapté pour fournir une tension Vc continue de polarisation comprise entre 0V et 3V.

Il est à noter que le circuit de mise en forme d'impulsions est monté en série par rapport au dispositif optoélectronique, et peut donc être monté soit en série sur l'anode soit en série sur la cathode du dispositif optoélectronique. Ainsi, ladite borne de sortie du circuit de mise en forme d'impulsions peut être une borne destinée à être reliée à une anode du dispositif optoélectronique alors que la cathode du dispositif optoélectronique est reliée à la borne négative du générateur de créneaux de tension. En variante, ladite borne de sortie du circuit de mise en forme d'impulsions peut être au contraire une borne destinée à être reliée à une cathode du dispositif optoélectronique alors que l'anode du dispositif optoélectronique est reliée à la borne positive du générateur de créneaux de tension. Dans tous les cas, ledit circuit redresseur à tension de seuil non nulle -et notamment chaque diode Schottky ou PIN- est monté en sens direct par rapport à la borne d'alimentation du dispositif optoélectronique à laquelle le circuit de mise en forme d'impulsions est relié.

Par ailleurs, avantageusement et selon l'invention, le générateur de créneaux de tension comprend un dispositif de mise en forme de créneaux de tension à diode de commutation à mémoire électrostatique (en anglais : « Step Recovery Diode »). Il s'est avéré en effet qu'un tel dispositif à diode de commutation à mémoire électrostatique procure un résultat particulièrement étonnant, en combinaison avec le circuit de mise en forme d'impulsions conformes à l'invention.

De préférence, le générateur de créneaux de tension comprend un générateur de signal périodique alimentant ledit dispositif de mise en forme de créneaux de tension.

L'invention concerne également un circuit caractérisé en combinaison par tout ou partie des caractéristiques mentionnées ci-dessus ou ci-après.

D'autres buts, caractéristiques et avantages de l'invention apparaîtront à la lecture de la description suivante de différents modes de réalisation de l'invention donnés uniquement à titre d'exemples non limitatifs, qui se réfère aux figures annexées dans lesquelles :

- la figure 1 est un schéma synoptique illustrant un circuit de pilotage selon l'invention reliée à une diode LED,
- les figures 2a, 2b et 2c sont des schémas électroniques de trois exemples de réalisation du circuit de mise en forme d'impulsions d'un circuit de pilotage selon l'invention,
- la figure 3 est un schéma électronique d'un mode de réalisation du circuit de mise en forme de créneaux de tension d'un circuit de pilotage selon l'invention,
- la figure 4 est un diagramme illustrant l'allure des créneaux de tension fournis sur la sortie du module de mise en forme de créneaux de tension de la figure 3,
- la figure 5 est un diagramme illustrant des courbes d'apparition de l'intensité d'électroluminescence normalisée d'une diode LED sans tension de polarisation et selon le circuit de pilotage utilisé,
- la figure 6 est un diagramme illustrant des courbes de déclin de l'intensité de l'électroluminescence normalisée d'une diode LED sous tension de polarisation et selon le circuit de pilotage utilisé,
- la figure 7 est un diagramme illustrant une courbe caractéristique intensité/tension d'une première diode LED émettant dans le domaine visible,
- la figure 8 est un diagramme illustrant une courbe caractéristique capacité de jonction/tension de la première diode LED,
- la figure 9 est un diagramme illustrant des courbes d'évolution de l'intensité de l'électroluminescence normalisée de la première diode LED en mode impulsionnel selon le circuit de pilotage utilisé,
- la figure 10 est un diagramme illustrant une courbe caractéristique intensité/tension d'une deuxième diode LED émettant dans le domaine ultraviolet,
- la figure 11 est un diagramme illustrant une courbe caractéristique capacité de jonction/tension de la deuxième diode LED,
- la figure 12 est un diagramme illustrant la courbe d'évolution de l'intensité de l'électroluminescence normalisée de la deuxième diode LED en mode impulsionnel,
- la figure 13 est un diagramme illustrant les variations de l'électroluminescence au cours du temps de la première diode LED pilotée à haute fréquence avec un circuit selon l'invention,
- la figure 14 est un diagramme similaire à la figure 13 pour une troisième diode LED émettant à 850 nm,
- la figure 15 est un diagramme illustrant des courbes d'évolution de l'intensité de l'électroluminescence normalisée d'une quatrième diode LED à 40 MHz selon le circuit de pilotage utilisé,
- la figure 16 est un diagramme illustrant des courbes d'évolution de l'intensité de l'électroluminescence normalisée de la quatrième diode LED à 300 MHz selon le circuit de pilotage utilisé.

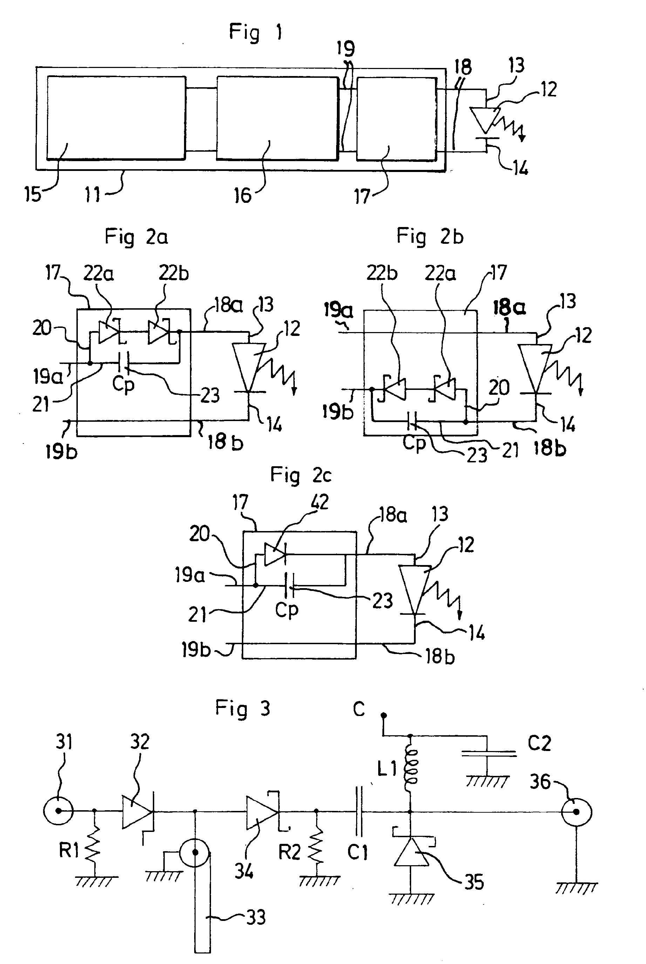

Dans l'exemple de la figure 1, un circuit de pilotage 11 selon l'invention est relié aux bornes (anode 13 et cathode 14) d'une diode LED 12. Ce circuit de pilotage 11 comprend successivement un générateur 15 de signal périodique, un circuit 16 de mise en forme de créneaux de tension à partir du signal fourni par le générateur 15, et un circuit 17 de mise en forme d'impulsions de commande de la diode LED 12 à partir des créneaux de tension fournis par le circuit 16 de mise en forme de créneaux de tension.

Des modes de réalisation du circuit 17 de mise en forme d'impulsions sont représentés plus en détail figures 2a à 2c.

Ce circuit 17 comprend une sortie 18 comprenant une borne 18a reliée à l'anode 13 de la diode LED 12, et une borne 18b reliée à la cathode 14 de la diode LED 12. Le circuit 17 comprend aussi une entrée 19 comprenant deux bornes 19a, 19b reliées aux bornes de sortie correspondantes du générateur 15 de créneaux de tension.

Entre une borne 19a ou 19b d'entrée et la borne de sortie 18a ou 18b correspondante (c'est-à-dire de même polarité), le circuit 17 comprend deux branches 20, 21 montées en parallèle l'une par rapport à l'autre. L'autre borne 19b ou 19a d'entrée est directement reliée à l'autre borne de sortie 18b ou 18a correspondante.

La première branche 20 est formée d'un circuit redresseur passif à tension de seuil non nulle, notamment constitué d'au moins une diode 22a, 22b, 42 montée en série dans cette branche 20 et en sens direct par rapport à la diode LED 12.

Dans le premier mode de réalisation de la figure 2a, les deux branches 20, 21, et donc la borne 18a de sortie de polarité positive, sont reliées à l'anode 13 de la diode LED 12, cette anode 13 faisant office de borne d'alimentation de la diode LED 12. La cathode 14 de la diode LED 12 est directement reliée à l'autre borne 18b de sortie de polarité négative, et donc également à la borne 19b d'entrée de polarité négative. La première branche 20 est constituée d'au moins une diode Schottky 22a, 22b montée en série dans la première branche 20 et en sens direct par rapport à la diode LED 12.

Dans le deuxième mode de réalisation représenté figure 2b, les deux branches 20, 21 ainsi que la borne 18b de sortie de polarité négative, sont reliées à la cathode 14 de la diode LED 12, cette cathode 14 faisant office de borne d'alimentation de la diode LED 12 l'anode 13 de la diode LED 12 est directement reliée à l'autre borne 18a de sortie de polarité positive, et donc également à la borne 19a d'entrée de polarité positive.

Le troisième mode de réalisation représenté figure 2c est similaire au premier mode de réalisation de la figure 2a, et n'en diffère que par le fait que la première branche 20 est formée d'une diode PIN (« positive intrinsèque négative ») 42 montée en série dans la première branche 20 et en sens direct par rapport à la diode LED 12.

Quoi qu'il en soit, chaque diode Schottky 22a, 22b ou PIN 42, est montée en sens direct, c'est-à-dire dans le même sens que la diode LED 12.

Chaque diode Schottky 22a, 22b présente typiquement une tension de seuil de l'ordre de 0,3 V à 0,35 V, une résistance dynamique de l'ordre de 6 $\Omega$, et une bande passante de l'ordre de 10 GHz. De préférence, le nombre de diodes Schottky 22a, 22b dans la première branche 20 est adapté pour que cette première branche 20 présente une tension de seuil totale supérieure à 0,5 V, notamment de l'ordre de 0,6 V à 0,7 V, et une résistance dynamique inférieure à 50 $\Omega$, notamment de l'ordre de 20 $\Omega$. Chaque diode PIN 42 présentes une tension de seuil de l'ordre de 0.9V à 1V, une résistance dynamique de l'ordre de 0.5 $\Omega$ à 1 $\Omega$, et une bande passante de l'ordre de 1 GHz à 5 GHz.

Dans les deux premiers modes de réalisation préférentiels représentés figures 2a et 2b, la première branche 20 comprend deux diodes Schottky 22a, 22b identiques en série. Dans le troisième mode de réalisation préférentiel représentée figure 2c, la première branche 20 comprend une unique diode PIN 42, par  exemple une diode silicium Philips® référence BAP 1321-04 présentant une tension de seuil de 0,95 V, une bande passante de 3 GHz et une résistance dynamique de 0,85 $\Omega$.

La deuxième branche 21 est une branche capacitive, c'est-à-dire présente une capacité de valeur prédéterminée Cp entre la borne 19a ou 19b d'entrée et la borne 18a ou 18b de sortie, en parallèle avec les diodes Schottky 22a, 22b. De préférence, la deuxième branche 21 est exclusivement capacitive, c'est-à-dire que les composantes résistives et inductives de son impédance sont négligeables entre la borne 19a ou 19b d'entrée et la borne 18a ou 18b de sortie. La valeur de la capacité Cp de la deuxième branche 21 capacitive peut être obtenue selon toute manière appropriée. Le plus simple est de prévoir que la deuxième branche 21 soit formée par un condensateur 23 monté entre la borne 19a ou 19b d'entrée et la borne 18a ou 18b de sortie.

Le nombre de diodes Schottky de la première branche 20 peut être différent de 2. Ce nombre est déterminé de façon à trouver le meilleur compromis entre :

- la charge Q stockée dans la deuxième branche capacitive 21, dont la valeur maximum sous tension de polarisation est :

$$Q = n.Vs.Cp$$

n étant le nombre de diodes Schottky,
Vs étant la tension de seuil de chaque diode Schottky, typiquement de l'ordre de 0,3 V à 0,35 V,

- la valeur de l'intensité maximum du courant des impulsions de commande fournies : c'est intensité est d'autant plus grande que la somme des résistances dynamiques des diodes Schottky 22a, 22b est faible, c'est-à-dire que n est faible. Plus la valeur de l'intensité maximum des impulsions est grande, plus la puissance optique émise par la diode LED 12 est grande.

Par ailleurs, la valeur de la capacité Cp de la deuxième branche capacitive 21 est comprise entre 10 pF et 200 pF, et optimisée pour être adaptée à la  capacité de jonction Cj présentée par le dispositif optoélectronique (diode LED 12) piloté.

Si $Cj_0$ est la capacité de jonction sous tension nulle de la diode LED 12, on peut choisir une capacité Cp comprise entre $0,2.Cj_0$ et $2.Cj_0$, soit entre 5 pF et 50 pF pour les LEDs du commerce, notamment de l'ordre de 10 pF à 20 pF. Cela étant cette optimisation doit être réalisée par des essais successifs, compte tenu du fait que la capacité de jonction Cj dépend de la tension appliquée aux bornes de la diode LED 12, qui ne présente pas un comportement électrique linéaire.

Dans un circuit selon l'invention, le circuit de mise en forme d'impulsions de commande doit être alimenté par des créneaux de tension présentant des fronts montants et descendants de très faible durées $\tau_r$, $\tau_f$, inférieures à 400 ps, typiquement comprises entre 50 ps et 400 ps, par exemple de l'ordre de 100 ps à 350 ps. La durée $\tau_p$ de chaque créneau de tension dans sa portion où la tension est constante est supérieure à la durée de chaque front du créneau et est comprise entre 250 ps et 4 ns.

L'amplitude maximum en tension Vmax de chaque créneau de tension est comprise entre 0 V et 4 V, par exemple de l'ordre de 2 V, et est de préférence ajustable.

Le générateur 15 de signal périodique et le circuit 16 de mise en forme de créneaux de tension constituent un générateur 15, 16 de créneaux de tension tels que mentionné ci-dessus.

Le générateur 15 de signal périodique est par exemple un générateur de signal sinusoïdal du commerce fournissant un signal dont la fréquence détermine celle des créneaux de tension, et donc celle des impulsions de commande qui doivent être appliquées au dispositif 12 optoélectronique. Par exemple, le générateur 15 de signal périodique est choisi pour pouvoir fournir un signal de fréquence comprise entre 1Hz et 2GHz, notamment entre 1Hz et 80MHz pour les applications de l'invention dans l'instrumentation scientifique, et entre 600MHz et 1GHz pour les applications de l'invention dans le domaine des télécommunications optiques, et d'amplitude comprise entre 0 V et 10 V, notamment de l'ordre de 5 V.

La figure 3 représente un schéma d'un mode de réalisation du circuit 16 de mise en forme de créneaux de tension. Ce circuit comprend successivement une entrée 31 coaxiale SMA recevant le signal périodique fourni par le générateur 15, une résistance R1 parallèle, une diode 32 de commutation à mémoire électrostatique (diode dite «SRD ») montée en série et en sens direct, une ligne 33 à retard variable pouvant être formée d'un câble semi rigide dont la longueur peut être ajustée, une diode Schottky 34 montée en série et en sens direct, une résistance R2 parallèle, un condensateur série de capacité C1, une diode Schottky 35 montée en parallèle et en sens inverse, une inductance parallèle L1 alimentée par une source de tension continue Vc de polarisation via un condensateur parallèle de filtrage de capacité C2, et une sortie 36 coaxiale SMA.

Par exemple, le circuit 16 peut être réalisé avec les valeurs suivantes : R1 = 56 $\Omega$, R2 = 100 $\Omega$, C1 = 470 nF, L1 = 33 $\mu$H, C2 = 100 nF.

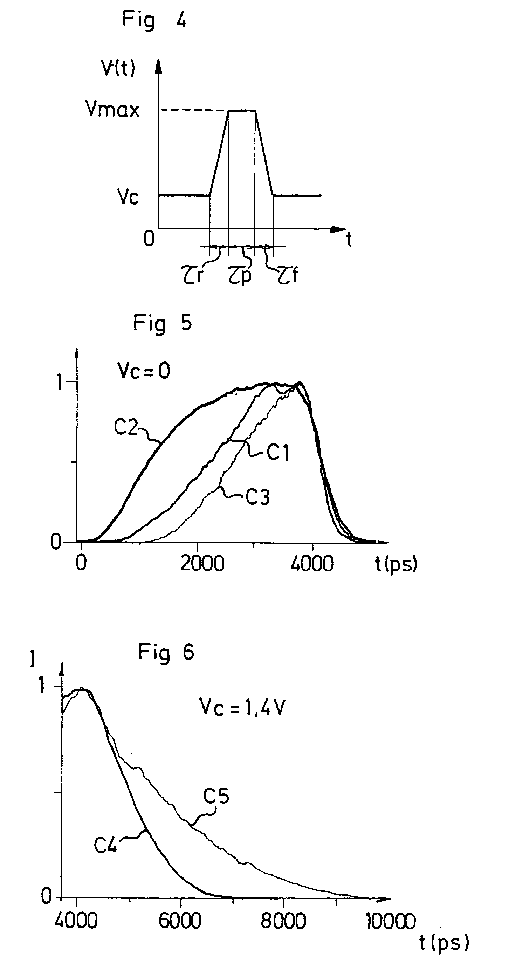

La figure 4 illustre l'allure d'un créneau de tension délivré sur la sortie 36 du circuit 16.

Si l'invention est destinée à piloter une source de lumière pulsée utilisée dans une chaîne d'instrumentation scientifique (fluorescence résolue en temps, détection optique de molécules, fluorescence de protéines, ...), cette source de lumière doit être pilotée en fonctionnement impulsionnel à faible fréquence de répétition. Il convient alors de trouver un compromis entre la largeur de chaque impulsion optique la plus courte possible, et la puissance optique la plus élevée possible.

Si l'invention est destinée à piloter une source de lumière pulsée utilisée pour des télécommunications à faibles distances, cette source de lumière doit être pilotée en fonctionnement impulsionnel à très haute fréquence de répétition. Il convient alors de trouver un compromis entre la fréquence de répétition la plus élevée possible et la puissance optique la plus élevée possible.

Dans la pratique, selon l'application de l'invention, la valeur de la tension de polarisation Vc superposée à la tension créneau produite par le circuit 16 est ajustée pour trouver le meilleur compromis.

Les performances du générateur 15, 16 de créneaux de tension dépendent notamment de la tension délivrée par le générateur 15 de signal périodique, et des caractéristiques de la diode 32 de commutation à mémoire électrostatique du circuit 16 de mise en forme de créneaux de tension. Dans les exemples mentionnés ci-après, deux montages A et B différents ont été utilisés.

Montage A : on utilise une diode 32 de commutation à mémoire électrostatique dont le temps de montée est de 35 ps (par exemple la diode SRD référence MMDB830-E28 commercialisée par la société Aeroflex Metelics (NH 03053, USA, http://www.aeroflex.com/ams/metelics)). Le circuit 16 est alimenté par un générateur 15 de signal sinusoïdal avec une amplitude efficace variant de 0 à 90 mV. Un amplificateur par exemple de type Minicircuit ZHL-42W (http://www.mini-circuit.com ; non représenté) permet si nécessaire d'amplifier l'amplitude (gain 30dB). Le temps de montée (et de descente) de chaque créneau produit par le circuit 16 est compris entre 100 et 200 ps, et la durée du créneau est de 250 ps à 2 ns (selon la longueur de la ligne à retard 33). La tension maximum Vmax de sortie pic à pic est de l'ordre de 3V et la fréquence de répétition de l'ordre de 600 MHz à 1,1 GHz. Ce montage A peut être utilisé pour les applications de l'invention dans les chaînes d'instrumentations scientifiques à basses fréquences et pour les applications de l'invention dans les télécommunications à hautes fréquences.

Montage B : on utilise une diode 32 de commutation à mémoire électrostatique dont le temps de montée est de 70 ps (par exemple une diode SRD référence SMMD835-E28 commercialisée par la société Aeroflex Metelics (NH 03053, USA, http://www.aeroflex.com/ams/metelics)). Le circuit 16 est alimenté par un générateur 15 de signal en créneaux présentant des temps de montée et descente de chaque créneau de l'ordre de 3ns (temps mesuré lorsque le signal passe de 10% à 90% de sa valeur finale), un niveau bas variant entre -0,6V et -7V et un niveau haut de 3V, et une durée de créneau de l'ordre de 20 ns. Le temps de montée (et de descente) de chaque créneau produit par le circuit 16 de mise en forme des créneaux de tension est de l'ordre de 200 ps à 300 ps, et la durée du créneau est de 0,5 ns à 4 ns selon la longueur de la ligne à retard 33. La tension maximum Vmax de sortie pic à pic est de l'ordre de 4 V et la fréquence de répétition maximum de l'ordre de 200 MHz. Ce montage B peut être utilisé pour les applications de l'invention dans les chaînes d'instrumentations scientifiques, ainsi que pour caractériser les temps de montée et de déclin de l'électroluminescence des LEDs du commerce à basse fréquence de répétition (inférieure ou égale à 100 MHz).

Dans les essais réalisés, l'électroluminescence d'une LED 12 alimentée par un circuit de pilotage selon l'invention est mesurée grâce à un détecteur ultra- rapide. Ce détecteur est formé d'une caméra à balayage de fente commercialisée sous la référence « streakscope C4334 » par la société Hamamatsu (http: //www.hamamatsu.com) équipée d'une photocathode commercialisée par cette même société sous la référence S20 (C4334- 02) . La résolution temporelle dépend de l'échelle de balayage choisie : 25 ps pour une échelle de balayage de 1ns, 125 ps pour 5 ns. Le détecteur est synchronisé par rapport à l'impulsion électrique envoyée sur la LED. L'électroluminescence de la LED est collectée par une première lentille et est focalisée par une deuxième lentille dans un spectromètre (focale : 25 cm, réseau 600 traits/mm, dispersion de 5nm/mm) . La lumière est ensuite focalisée sur la fente d'entrée du détecteur. Le signal mesuré est donc l'intensité de luminescence en fonction du temps et de la longueur d'onde. Comme on intègre numériquement sur toute la largeur spectrale de l'émission, on obtient finalement l'intensité de luminescence en fonction du temps. Le courant est mesuré par une résistance de charge de 1 $\Omega$ en série sur la LED 12 et d'un oscilloscope branché en parallèle aux bornes de cette résistance, la bande passante du montage de détection du courant étant de l'ordre de 2 GHz.

Exemple 1 : fonctionnement sans polarisation :

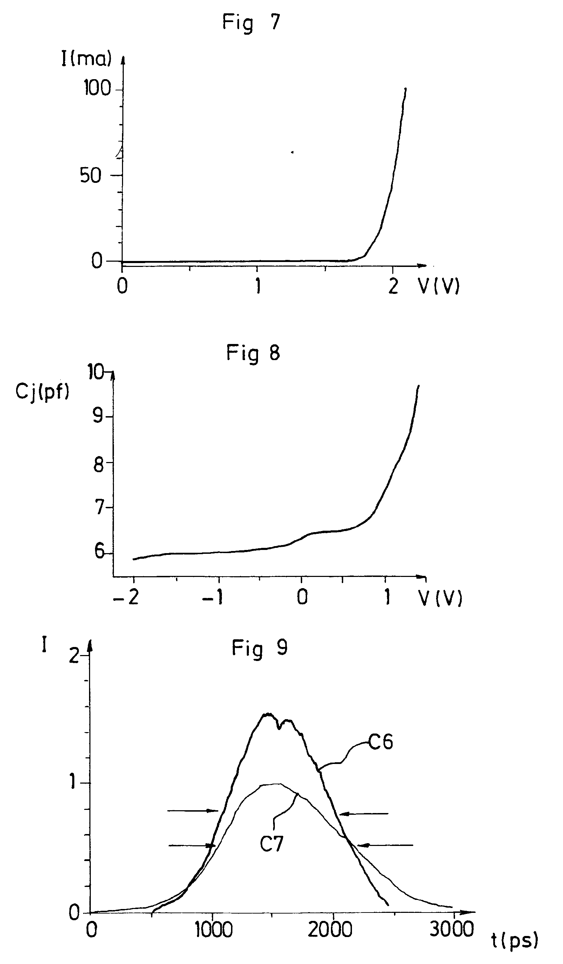

Dans cet exemple, on a utilisé le montage B pour piloter une diode LED 12 émettant à une longueur d'onde de 650 nm commercialisée sous la référence L9907 par la société Hamamatsu (http://www.hamamatsu.com). Les caractéristiques de cette LED sont représentées figures 7 et 8. Sa tension de seuil est de 1,7 V. Sa capacité sous tension nulle $Cj_0$ est de 6 pF.

Le circuit 17 de mise en forme d'impulsions de commande est conforme à la figure 2a et comporte deux diodes Schottky. On choisit Vc = 0V, $\tau_r$ = $\tau_f$ = 350 ps, $\tau_p$ = 4 ns, Vmax = 1,5 V.

La courbe C1 de la figure 5 est obtenue avec un circuit selon l'invention pour Cp = 100 pF. La courbe C2 de la figure 5 est obtenue avec un circuit selon l'invention pour Cp = 22 pF.

À titre d'essai comparatif, la courbe C3 de la figure 5 est obtenue avec un circuit non conforme à l'invention dans lequel le circuit 17 de mise en forme d'impulsions de commande selon l'invention est remplacé par une résistance série de 33 $\Omega$.

L'instant initial d'apparition de l'électroluminescence et le temps de montée de l'électroluminescence sont contrôlées par la charge de la capacité Cj de la LED 12. Comme on le voit, l'invention permet de réduire d'une part la durée d'apparition de l'électroluminescence et d'autre part la durée de la montée de l'électroluminescence.

Lorsque la tension de polarisation Vc est nulle, la durée de déclin de l'électroluminescence est dans tous les cas essentiellement dépendante du balayage des porteurs de charges hors de la zone active lorsque la capacité Cj se décharge.

Exemple 2 : durée de déclin avec tension de polarisation non nulle :

Lorsque la LED 12 est alimentée avec une tension de polarisation Vc non nulle, on s'affranchit des phases de charges et de décharge de la capacité Cj. L'amplitude de la tension des impulsions de commande peut donc être plus faible, la tension de seuil de la LED étant déjà atteinte grâce à cette tension de polarisation. Ce mode de fonctionnement est en particulier intéressant dans les applications à haute fréquence.

Néanmoins, le temps de déclin de l'électroluminescence de la LED est alors essentiellement dépendant du temps de vie des porteurs de charge, et non plus du temps de balayage des porteurs de charges hors de la zone active. Il en résulte que ce temps de déclin de l'électroluminescence est plus long.

L'invention permet néanmoins de réduire le temps de déclin de l'électroluminescence sous polarisation, comme le montre l'exemple de la figure 6.

Dans cet exemple, on a utilisé la même LED que dans l'exemple 1. Le circuit 17 de mise en forme d'impulsions de commande comporte une diode Schottky. On choisit Vc = 1,4 V, $\tau_r$ = $\tau_f$ = 350 ps, $\tau_p$ = 4 ns, Vmax = 0,6 V.

La courbe C4 de la figure 6 est obtenue avec un circuit selon l'invention pour Cp = 100 pF.

À titre d'essai comparatif, la courbe C5 de la figure 6 est obtenue avec un circuit dans lequel le circuit 17 de mise en forme d'impulsions de commande selon l'invention est remplacé par une résistance série de 33$\Omega$.

Comme on le voit, le temps de déclin mesuré entre 90% et 10% de la valeur maximum de l'électroluminescence est de l'ordre de 1,6ns avec un circuit de pilotage selon l'invention, alors qu'il est de 3,5ns dans l'essai comparatif.

De façon générale, les meilleurs résultats ont été obtenus en utilisant une tension Vc de polarisation inférieure à la somme des tensions de seuil de la LED 12 et de la (des) diode(s) Schottky.

Exemple 3 : fonctionnement à faible fréquence de répétition :

Dans cet exemple, on utilise la même LED que dans l'exemple 1.

On réalise des essais avec un circuit de pilotage conforme à l'invention dans lequel le générateur 15, 16 est conforme au montage A. Le circuit 17 de mise en forme d'impulsions de commande est conforme à la figure 2a et comporte deux diodes Schottky. On choisit Vc = 1,92V, $\tau_r = \tau_f$ = 200ps, $\tau_p$ = 0,5ns, Vmax = 0,9V. La fréquence de répétition des impulsions est de 80 MHz. L'intensité de pilotage de la LED est de 100mA. La puissance pic à pic est de 206$\mu$W.

La courbe C6 de la figure 9 représente l'intensité d'électroluminescence normalisée émise par la LED et est obtenue avec un circuit selon l'invention pour Cp = 10pF.

À titre d'essai comparatif, la courbe C7 de la figure 9 est obtenue avec un circuit dans lequel les diodes Schottky du circuit 17 de mise en forme d'impulsions de commande selon l'invention sont remplacées par une résistance série de 30$\Omega$ avec Vc = 1,5V, Vmax = 0,75V, et une intensité de pilotage de 100mA et une puissance pic à pic de 105$\mu$W. La courbe C7 représente donc les résultats obtenus avec un circuit R-C parallèle connu de mise en forme d'impulsions, non conforme à l'invention.

Le Tableau 1 ci-après illustre les différents résultats obtenus dans cet exemple.

Tableau 1

| $\tau_p$ | Circuit R-C parallèle (essai comparatif) | | | Circuit de l'invention | | |
|---|---|---|---|---|---|---|
| | Puissance moyenne à 80 MHz | Puissance pic à pic | Impulsion lumineuse (FWHM) | Puissance moyenne à 80 MHz | Puissance pic à pic | Impulsion lumineuse (FWHM) |
| 500ps | 9.7$\mu$W | 0.10mW | 1150ps | 15$\mu$W | 0.20mW | 920ps |
| 1ns | 25$\mu$W | 0.25mW | 1200ps | 36$\mu$W | 0.40mW | 1200ps |
| 2ns | 61$\mu$W | 0.40mW | 1860ps | 80$\mu$W | 0.5 mW | 1760ps |

La comparaison entre le circuit de pilotage selon l'invention à diodes Schottky et capacité parallèle, et le circuit de pilotage à base de circuit R-C parallèle montre que, pour un même courant, le circuit de pilotage selon l'invention conduit à :

- une puissance optique plus élevée (jusqu'à un facteur 2) grâce à un effet de pic d'intensité initial plus important,
- une durée d'impulsion lumineuse plus courte (jusqu'à 20%).

Aucune explication claire ne peut être donnée à ces résultats inattendus.

Par ailleurs, les performances obtenues avec le circuit de pilotage selon l'invention sont similaires à celles obtenues avec des circuits de pilotage de l'état de la technique antérieure à base de composants actifs, beaucoup plus onéreux et sensibles à la température.

L'invention peut donc être appliquée en particulier pour piloter un dispositif optoélectronique dans une instrumentation scientifique de façon à produire des impulsions très courtes à une fréquence relativement basse.

Exemple 4 : LED UV :

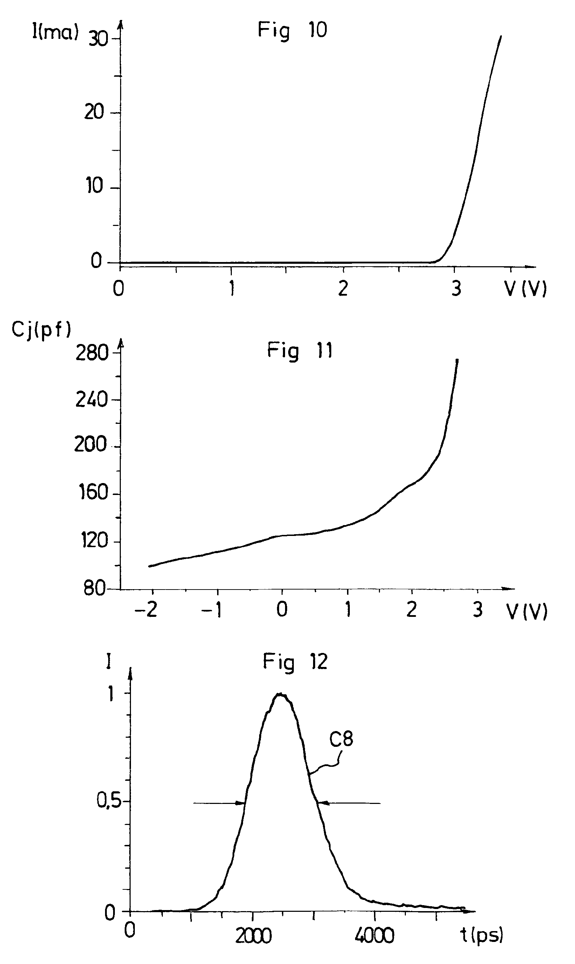

Cet exemple est similaire à l'exemple 3, mais a été effectué avec une LED 12 émettant dans les ultraviolets, à savoir une LED commercialisée sous la référence HUV400- 5X0B par la société Hero- Led (http: //www.hero- led.com) . Les caractéristiques de cette LED sont représentées figures 10 et 11. Sa tension de seuil est de 2, 75V. Sa capacité sous tension nulle $Cj_0$ est de 125pF. Sa longueur d'onde centrale d'émission est de 400 nm avec une largeur spectrale de 20nm.

On choisit le montage A, et Vc = 2,7V, $\tau_r = \tau_f$ = 200ps, $\tau_p$ = 0,5ns, Vmax = 3V. La fréquence de répétition des impulsions est de 80MHz. L'intensité de pilotage de la LED est de 300mA. La puissance pic à pic est de 1800$\mu$W. Le circuit 17 de mise en forme d'impulsions de commande comporte deux diodes Schottky et Cp = 22pF.

La figure 12 représente la courbe C8 illustrant l'intensité de l'électroluminescence normalisée émise par la LED en mode impulsionnel.

Le Tableau 2 ci-après illustre les différents résultats obtenus dans cet exemple.

Tableau 2

| $\tau_p$ | Circuit de l'invention | | |
|---|---|---|---|
| | Puissance moyenne à 40 MHz | Puissance pic à pic | Impulsion lumineuse (FWHM) |
| 500ps | 80$\mu$W | 1.8mW | 1100ps |
| 1ns | 163$\mu$W | 3.3mW | 1250pas |
| 2ns | 310$\mu$W | 5.5mW | 1400ps |

Exemple 5 : fonctionnement à haute fréquence :

Dans cet exemple, on montre qu'un circuit de pilotage conforme à l'invention permet d'obtenir une modulation large signal de 500MHz à 1GHz avec une puissance pic à pic de 20$\mu$W à 100$\mu$W.

On réalise des essais avec une LED 12 identique à celle de l'exemple 1, avec un circuit de pilotage conforme à l'invention dans lequel le générateur 15, 16 est conforme au montage A. Le circuit 17 de mise en forme d'impulsions de commande est conforme à la figure 2a et comporte deux diodes Schottky. On choisit Vc = 0,6V, $\tau_r = \tau_f$ = 200ps, $\tau_p$ = 0,5ns, Vmax = 2,5V, Cp = 10pF. La fréquence de répétition des impulsions est de IGHz. L'intensité de pilotage de la LED est de 75mA. La puissance pic à pic est de 45$\mu$W.

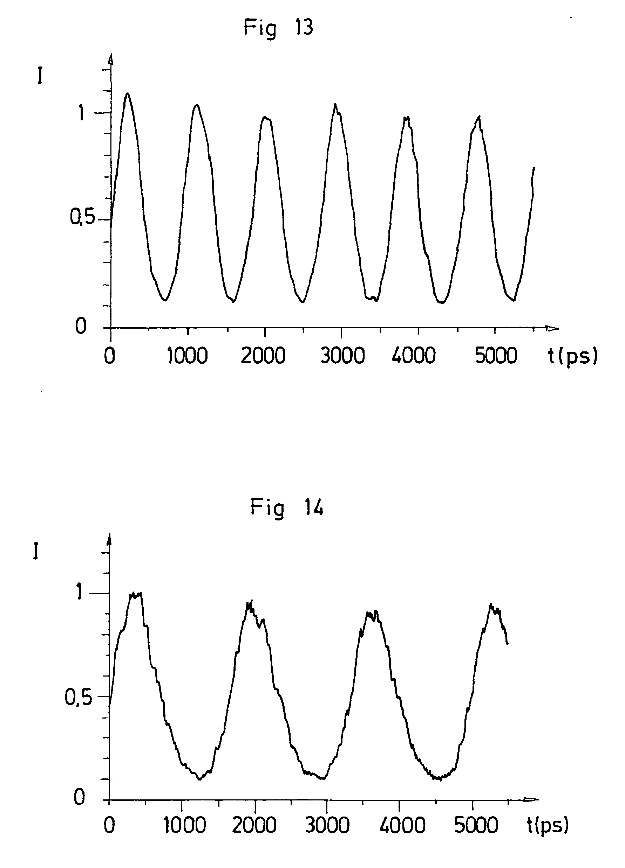

La figure 13 illustre l'évolution de l'intensité de l'électroluminescence normalisée en fonction du temps.

Le tableau 3 ci-après illustre les différents résultats obtenus avec cette LED, y compris ceux d'un essai comparatif effectué avec un circuit de pilotage R-C parallèle comme dans l'exemple 3.

Tableau 3

| Fréquence | Intensité | Circuit R-C parallèle (essai comparatif) | Circuit de l'invention |
|---|---|---|---|
| | | Puissance pic à pic | Puissance pic à pic |
| 500MHz | 100mA | 40$\mu$W | 95$\mu$W |
| 600MHz | 100mA | 24$\mu$W | 85$\mu$W |
| 1GHz | 75mA | 10$\mu$W | 45$\mu$W |

Exemple 6 : LED à 850 nm :

Cet exemple est similaire à l'exemple 5, mais on utilise une LED 12 différente, à savoir une LED commercialisée sous la référence OP245PS par la société Optek (http://www.optekinc.com) émettant à une longueur d'onde de 850 nm, présentant une tension de seuil de 1,5 V, et une capacité sous tension nulle Cj$_0$ de 50 pF. Une telle longueur d'onde présente un intérêt notamment pour les télécommunications par fibre optique.

On réalise l'essai avec un circuit de pilotage conforme à l'invention dans lequel le générateur 15, 16 est conforme au montage A. Le circuit 17 de mise en forme d'impulsions de commande est conforme à la figure 2a et comporte deux diodes Schottky. On choisit Vc = 0V, $\tau_r = \tau_f$ = 200ps, $\tau_p$ = 0,5ns, Vmax = 3V, Cp = 10pF. La fréquence de répétition des impulsions est de 600MHz. L'intensité de pilotage de la LED est de 100mA. La puissance pic à pic est de 20$\mu$W. la puissance moyenne est de 8$\mu$W.

La figure 14 illustre l'évolution de l'intensité de l'électroluminescence normalisée en fonction du temps.

Exemple 7 :

Cet exemple est similaire à l'exemple 3, mais a été effectué avec une LED commercialisée sous la référence RCXR65- RSPOU de la société Roithner (http: //www.roithner- laser.com) et avec trois circuits de mise en forme d'impulsions de commande distincts : un premier circuit 17 conforme à la figure 2a dont le circuit redresseur passif à tension de seuil non nulle comporte deux diodes Schottky ; un deuxième circuit 17 conforme à la figure 2c dont le circuit redresseur passif à tension de seuil non nulle comporte une diode PIN ; et à titre comparatif, un troisième circuit non conforme à l'ivention dans lequel la LED est pilotée sans driver (une résistance de 28 $\Omega$ est cependant placée en série sur la LED pour réaliser l'accord d'impédance) .

La diode PIN présente une tension de seuil de 0,95V, une bande passante de 3GHz, et une résistance dynamique de 0,85 $\Omega$.

La LED présente une tension de seuil de 1,75V, et une capacité de jonction sous tension nulle Cj$_0$ de 13,5 pF. Sa longueur d'onde centrale d'émission est de 650 nm.

On choisit Vc = 1,5V, $\tau_r = \tau_f$ = 100ps, $\tau_p$ = 1ns, Vmax = 5V, Cp = 22pF. Le circuit 16 est alimenté par un générateur 15 de signal sinusoïdal avec une amplitude pouvant atteindre 150mV, et la fréquence de répétition des impulsions est dans cet exemple de 40 MHz.

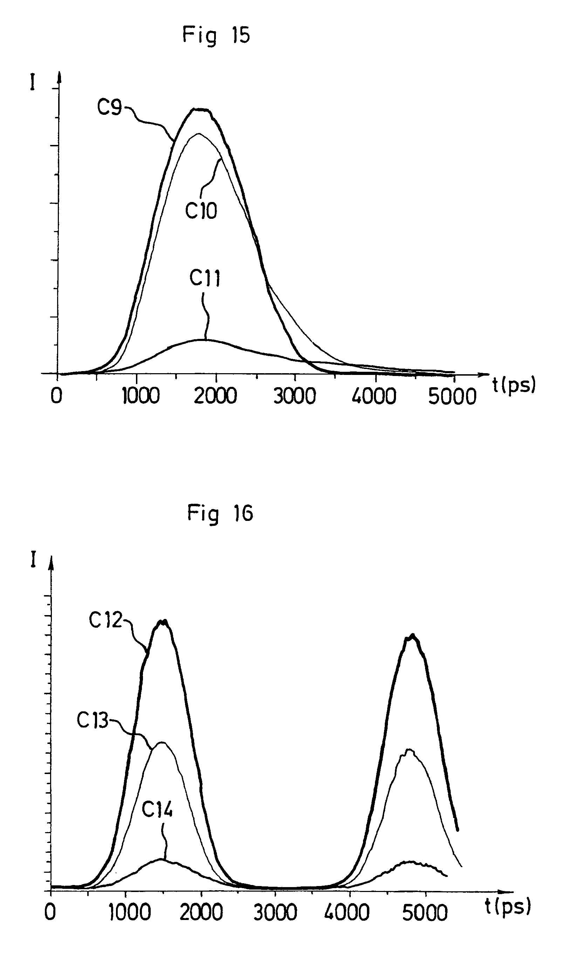

La courbe C9 de la figure 15 représente l'intensité d'électroluminescence normalisée émise par la LED et est obtenue avec le premier circuit selon l'invention à diodes Schottky. La courbe C10 de la figure 15 représente l'intensité d'électroluminescence normalisée émise par la LED et est obtenue avec le deuxième circuit selon l'invention à diode PIN.

À titre d'essai comparatif, la courbe C11 de la figure 15 est obtenue avec le troisième circuit, non conforme à l'invention.

Comme on le voit les résultats obtenus avec les deux circuits conforme à l'invention sont similaires (durée de l'impulsion lumineuse de l'ordre de 1,36 ns) et très nettement différents et supérieurs à ceux obtenus avec le circuit non conforme à l'invention.

Exemple 8 :

Cet exemple est similaire à l'exemple 7 et ne s'en distingue que par la fréquence de répétition qui est de 300 MHz (et non de 40 MHz comme dans l'exemple 7).

La courbe C12 de la figure 16 représente l'intensité d'électroluminescence normalisée émise par la LED et est obtenue avec le premier circuit selon l'invention à diodes Schottky. La courbe C13 de la figure 16 représente l'intensité d'électroluminescence normalisée émise par la LED et est obtenue avec le deuxième circuit selon l'invention à diode PIN.

À titre d'essai comparatif, la courbe C13 de la figure 16 est obtenue avec le troisième circuit, non conforme à l'invention.

Là encore, on constate que les résultats obtenus avec les deux circuits conformes à l'invention sont nettement supérieurs à ceux obtenus avec le circuit non conforme à l'invention. En outre, les résultats obtenus avec le premier circuit conforme à l'invention dont le circuit redresseur passif à tension de seuil non nulle est composé de deux diodes Schottky en série, sont supérieurs à ceux obtenus avec le deuxième circuit conforme à l'invention dont le circuit redresseur passif à tension de seuil non nulle est composé d'une diode PIN. La durée de l'impulsion lumineuse est de 0,875 ns avec le premier circuit conforme à l'invention, de 0,839 ns avec le deuxième circuit conforme à l'invention, et de 0,966 ns avec le troisième circuit non conforme à l'invention.

**Revendications**

1. Circuit de pilotage ultrarapide d'un dispositif optoélectronique comprenant au moins une diode (12) optoélectronique, le circuit comprenant:

   - un générateur (15, 16) de créneaux de tension présentant des fronts de durée inférieure à 400 ps,
   - un circuit (17) de mise en forme d'impulsions de commande du dispositif optoélectronique, ce circuit (17) de mise en forme d'impulsions comportant :

     - une sortie (18) adaptée pour être reliée au dispositif optoélectronique,
     - et une entrée (19) reliée au générateur (15, 16) de créneaux de tension et recevant les créneaux de tension formés par ce dernier,
     - entre une borne (19a ou 19b) de ladite entrée et une borne (18a ou 18b) de ladite sortie reliée en série à une borne (13 ou 14) d'alimentation du dispositif optoélectronique, montées en parallèle l'une par rapport à l'autre :

       - une première branche (20) formée d'un circuit (22a, 22b) redresseur passif à tension de seuil non nulle, en série dans la première branche et en sens direct par rapport à ladite borne (13 ou 14) d'alimentation du dispositif optoélectronique,
       - une deuxième branche (21) capacitive.

2. Circuit selon la revendication 1, **caractérisé en ce que** ledit circuit (22a, 22b) redresseur passif à tension de seuil non nulle est formé d'au moins une diode en série dans la première branche et en sens direct par rapport à ladite borne (13 ou 14) d'alimentation du dispositif optoélectronique.

3. Circuit selon l'une des revendications 1 ou 2, **caractérisé en ce que** ledit circuit (22a, 22b) redresseur passif à tension de seuil non nulle présente une tension de seuil totale supérieure à 0,5V et une résistance dynamique inférieure à 50$\Omega$.

4. Circuit selon l'une des revendications 1 à 3, **caractérisé en ce que** ledit circuit (22a, 22b) redresseur passif à tension de seuil non nulle comprend au moins une diode Schottky (22a, 22b).

5. Circuit selon l'une des revendications 1 à 4, **caractérisé en ce que** ledit circuit (22a, 22b) redresseur passif à tension de seuil non nulle est formé d'une pluralité de diodes Schottky (22a, 22b) en série.

6. Circuit selon la revendication 5, **caractérisé en ce que** ledit circuit (22a, 22b) redresseur passif à tension de seuil non nulle est formé de deux diodes Schottky en série, et **en ce que** chaque diode Schottky (22a, 22b) présente une tension de seuil de l'ordre de 0,3V à 0,35V, une résistance dynamique de l'ordre de 6$\Omega$, et une bande passante de l'ordre de 10GHz.

7. Circuit selon l'une des revendications 1 à 5, **caractérisé en ce que** ledit circuit (22a, 22b) redresseur passif à tension de seuil non nulle comprend au moins une diode PIN.

8. Circuit selon l'une des revendications 1 à 6, **caractérisé en ce que** ledit circuit (22a, 22b) redresseur passif à tension de seuil non nulle, est formé d'une diode PIN présentant une tension de seuil de l'ordre de 0.9V à 1V, une résistance dynamique de l'ordre de 0.5 Ω à 1 Ω, et une bande passante de l'ordre de 1 GHz à 5 GHz.

9. Circuit selon l'une des revendications 1 à 8, **caractérisé en ce que** la capacité de la deuxième branche (21) est comprise entre 0,2 fois et 2 fois la capacité du dispositif optoélectronique sous tension nulle.

10. Circuit selon l'une des revendications 1 à 9, **caractérisé en ce que** la capacité de la deuxième branche (21) est comprise entre 10pF et 200pF.

11. Circuit selon l'une des revendications 1 à 10, **caractérisé en ce que** le générateur (15, 16) de créneaux de tension est adapté pour produire des créneaux de tension d'amplitude crête comprise entre 0V et 4V de durée comprise entre 250ps et 4ns.

12. Circuit selon l'une des revendications 1 à 11, **caractérisé en ce que** le générateur (15, 16) de créneaux de tension est adapté pour fournir une tension Vc continue de polarisation de valeur inférieure à la tension de seuil totale de la première branche (20) et de chaque diode (12) optoélectronique du dispositif optoélectronique.

13. Circuit selon l'une des revendications 1 à 12, **caractérisé en ce que** le générateur (15, 16) de créneaux de tension est adapté pour fournir une tension Vc continue de polarisation comprise entre 0V et 3V.

14. Circuit selon l'une des revendications 1 à 13, **caractérisé en ce que** le générateur (15, 16) de créneaux de tension comprend un dispositif (16) de mise en forme de créneaux de tension à diode (32) de commutation à mémoire électrostatique.

15. Circuit selon la revendication 14, **caractérisé en ce que** le générateur (15, 16) de créneaux de tension comprend un générateur (15) de signal périodique alimentant ledit dispositif (16) de mise en forme de créneaux de tension.

**Patentansprüche**

1. Ultraschnelle Steuerschaltung einer optoelektronischen Vorrichtung, umfassend mindestens eine optoelektronische Diode (12), wobei die Schaltung Folgendes umfasst:

   einen Spannungsintervall-Generator (15, 16), der Vorderseiten mit einer Dauer von weniger als 400 ps aufweist,

   - eine Schaltung (17) zur Formung von Steuerimpulsen der optoelektronischen Vorrichtung, wobei diese Schaltung (17) zur Formung von Impulsen Folgendes umfasst:
   - einen Ausgang (18), der ausgelegt ist, um mit der optoelektronischen Vorrichtung verbunden zu sein,
   - und einen Eingang (19), der mit dem Spannungsintervall-Generator (15, 16) verbunden ist und die Spannungsintervalle erhält, die von diesem Letzteren gebildet werden,
   - zwischen einer Klemme (19a oder 19b) des genannten Eingangs und einer Klemme (18a oder 18b) des genannten Ausgangs, in Reihe verbunden mit einer Klemme (13 oder 14) zur Versorgung der optoelektronischen Vorrichtung, die mit Bezug aufeinander parallel montiert sind:
   - einen ersten Zweig (20), gebildet aus einer passiven Gleichrichterschaltung (22a, 22b) mit einer Schwellenspannung, die nicht gleich null ist, in Reihe im ersten Zweig und in Vorwärtsrichtung mit Bezug auf die genannte Klemme (13 oder 14) zur Versorgung der optoelektronischen Vorrichtung.
   - einen zweiten kapazitiven Zweig (21).

2. Schaltung nach Anspruch 1, **dadurch gekennzeichnet, dass** die genannte passive Gleichrichterschaltung (22a, 22b) mit einer Schwellenspannung, die nicht gleich null ist, aus mindestens einer Diode in Reihe im ersten Zweig gebildet ist, und in Vorwärtsrichtung mit Bezug auf die genannte Klemme (13 oder 14) zur Versorgung der optoelektronischen Vorrichtung.

3. Schaltung nach einem der Ansprüche 1 oder 2, **dadurch gekennzeichnet, dass** die genannte passive Gleichrichterschaltung (22a, 22b) mit einer Schwellenspannung, die nicht gleich null ist, eine gesamte Schwellenspannung aufweist, die höher als 0,5 V ist und einen dynamischen Widerstand von weniger als 50 $\Omega$ aufweist.

4. Schaltung nach einem der Ansprüche 1 bis 3, **dadurch gekennzeichnet, dass** die genannte passive Gleichrichterschaltung (22a, 22b) mit einer Schwellenspannung, die nicht gleich null ist, mindestens eine Schottky-Diode (22a, 22b) umfasst.

5. Schaltung nach einem der Ansprüche 1 bis 4, **dadurch gekennzeichnet, dass** die genannte passive Gleichrichterschaltung (22a, 22b) mit einer Schwellenspannung, die nicht gleich null ist, aus einer Vielzahl von Schottky-Dioden (22a, 22b) in Reihe gebildet ist.

6. Schaltung nach Anspruch 5, **dadurch gekennzeichnet, dass** die genannte passive Gleichrichterschaltung (22a, 22b) mit einer Schwellenspannung, die nicht gleich null ist, aus zwei Schottky-Dioden in Reihe gebildet ist, und dadurch, dass jede Schottky-Diode (22a, 22b) eine Schwellenspannung im Bereich von 0,3 V bis 0,35 V, einen dynamischen Widerstand im Bereich von 6 $\Omega$ und ein Breitband im Bereich von 10 GHz aufweist.

7. Schaltung nach einem der Ansprüche 1 bis 5, **dadurch gekennzeichnet, dass** die genannte passive Gleichrichterschaltung (22a, 22b) mit einer Schwellenspannung, die nicht gleich null ist, mindestens eine PIN-Diode umfasst.

8. Schaltung nach einem der Ansprüche 1 bis 6, **dadurch gekennzeichnet, dass** die genannte passive Gleichrichterschaltung (22a, 22b) mit einer Schwellenspannung, die nicht gleich null ist, aus einer PIN-Diode gebildet ist, die eine Schwellenspannung im Bereich von 0,9 V bis 1 V, einen dynamischen Widerstand im Bereich von 0,5 $\Omega$ bis 1 $\Omega$ und ein Breitband im Bereich von 1 GHz bis 5 GHz aufweist.

9. Schaltung nach einem der Ansprüche 1 bis 8, **dadurch gekennzeichnet, dass** die Kapazität des zweiten Zweigs (21) zwischen 0,2 Mal und 1 Mal der Kapazität der optoelektronischen Vorrichtung unter Spannung null liegt.

10. Schaltung nach einem der Ansprüche 1 bis 9, **dadurch gekennzeichnet, dass** die Kapazität des zweiten Zweigs (21) zwischen 10 pF und 200 pF liegt.

11. Schaltung nach einem der Ansprüche 1 bis 10, **dadurch gekennzeichnet, dass** der Spannungsintervall-Generator (15, 16) ausgelegt ist, um Spannungsintervalle mit einer Spitzenamplitude zwischen 0 V und 4 V und einer Dauer zwischen 250 ps und 4 ns zu erzeugen.

12. Schaltung nach einem der Ansprüche 1 bis 11, **dadurch gekennzeichnet, dass** der Spannungsintervall-Generator (15, 16) ausgelegt ist, um eine Polarisationsgleichspannung Vc mit einem Wert zu liefern, der kleiner als die gesamte Spannungsschwelle des ersten Zweigs (20) und jede optoelektronischen Diode (12) der optoelektronischen Vorrichtung ist.

13. Schaltung nach einem der Ansprüche 1 bis 12, **dadurch gekennzeichnet, dass** der Spannungsintervall-Generator (15, 16) ausgelegt ist, um eine Polarisationsgleichspannung Vc zwischen 0 V und 3 V zu liefern.

14. Schaltung nach einem der Ansprüche 1 bis 13, **dadurch gekennzeichnet, dass** der Spannungsintervall-Generator (15, 16) eine Vorrichtung (16) zur Formung von Spannungsintervallen mit Kommutationsdiode (32) mit elektrostatischem Speicher umfasst.

15. Schaltung nach Anspruch 14, **dadurch gekennzeichnet, dass** der Spannungsintervall-Generator (15, 16) einen Generator (15) eines periodischen Zeitsignals umfasst, der die genannte Vorrichtung (16) zur Formung eines Spannungsintervalls versorgt.

**Claims**

1. Circuit for high-speed drive of an optoelectronic device including at least one optoelectronic diode (12), wherein said circuit comprises:

   - a voltage square wave pulses generator (15, 16) exhibiting edges of duration shorter than 400 ps,

- a pulse-shaping circuit (17) for shaping of driving pulses of the optoelectronic device, said pulse-shaping circuit (17) including:

    an output (18) that is suitable to be connected to the optoelectronic device,

- and an input (19) connected to the voltage square wave pulses generator (15, 16) and receiving the voltage square wave pulses formed by said generator,
- between a terminal (19a or 19b) of said input and a terminal (18a or 18b) of said output connected in series to a terminal (13 or 14) for energizing said optoelectronic device, connected in parallel in relation to one another:
- a first branch (20) made up of a passive rectifier circuit (22a, 22b) with non-zero threshold voltage, said passive rectifier circuit being in series in the first branch and in the forward direction in relation to said terminal (13 or 14) for energizing the optoelectronic device,
- a second capacitive branch (21).

2. Circuit as claimed in Claim 1, wherein said passive rectifier circuit (22a, 22b) with non-zero threshold voltage is made up of at least one diode in series in the first branch and in the forward direction in relation to said terminal (13 or 14) for energizing the optoelectronic device.

3. Circuit as claimed in either Claim 1 or 2, wherein said passive rectifier circuit (22a, 22b) with non-zero threshold voltage exhibits a total threshold voltage greater than 0.5 V and a dynamic resistance less than 50 $\Omega$.

4. Circuit as claimed in Claim 1, wherein said passive rectifier circuit (22a, 22b) with non-zero threshold voltage includes at least one Schottky diode (22a, 22b).

5. Circuit as claimed in one of Claims 1 to 4, wherein said passive rectifier circuit (22a, 22b) with non-zero threshold voltage is made up of a plurality of Schottky diodes (22a, 22b) in series.

6. Circuit as claimed in Claim 5, wherein said passive rectifier circuit (22a, 22b) with non-zero threshold voltage is made up of two Schottky diodes in series, and in that each Schottky diode (22a, 22b) exhibits a threshold voltage of the order of 0.3 V to 0.35 V, a dynamic resistance of the order of 6 $\Omega$ and a pass-band of the order of 10 GHz.

7. Circuit as claimed in one of Claims 1 to 5, wherein said passive rectifier circuit (22a, 22b) with non-zero threshold voltage includes at least one PIN diode.

8. Circuit as claimed in one of Claims 1 to 6, wherein said passive rectifier circuit (22a, 22b) with non-zero threshold voltage is made up of a PIN diode exhibiting a threshold voltage of the order of 0.9 V to 1 V, a dynamic resistance of the order of 0.5 $\Omega$ to 1 $\Omega$ and a pass-band of the order of 1 GHz to 5 GHz.

9. Circuit as claimed in one of Claims 1 to 8, wherein the capacitance of the second branch (21) is between 0.2 times and 2 times the capacitance of the optoelectronic device under zero voltage.

10. Circuit as claimed in one of Claims 1 to 9, wherein the capacitance of the second branch (21) is between 10 pF and 200 pF.

11. Circuit as claimed in one of Claims 1 to 10, wherein the voltage square wave pulses generator (15, 16) is suitable to produce voltage square wave pulses of peak amplitude between 0 V and 4 V of duration between 250 ps and 4 ns.

12. Circuit as claimed in one of Claims 1 to 11, wherein the voltage square wave pulses generator (15, 16) is suitable to provide a DC bias voltage Vc of value less than the total threshold voltage of the first branch (20) and of each optoelectronic diode (12) of the optoelectronic device.

13. Circuit as claimed in one of Claims 1 to 12, wherein the voltage square wave pulses generator (15, 16) is suitable to provide a DC bias voltage Vc between 0 V and 3 V.

14. Circuit as claimed in one of Claims 1 to 13, wherein the voltage square wave pulses generator (15, 16) includes a device (16) for shaping of voltage square wave pulses with a switching diode (32) with electrostatic memory.

15. Circuit as claimed in Claim 14, wherein the voltage square wave pulses generator (15, 16) includes a periodic-signal generator (15) energizing said device (16) for shaping of voltage square wave pulses.

Fig 1

Fig 2a

Fig 2b

Fig 2c

Fig 3

Fig 4

$V(t)$

$Vmax$

$Vc$

$0$

$t$

$\mathcal{T}r$  $\mathcal{T}p$  $\mathcal{T}f$

Fig 5

$Vc = 0$

1

C2

C1

C3

0

0    2000    4000    t(ps)

Fig 6

I

1

$Vc = 1,4V$

C5

C4

0

4000    6000    8000    10000

t(ps)

Fig 7

I(ma)

100

50

0

0          1          2    V(V)

Fig 8

Cj(pf)

10
9
8
7
6

−2        −1        0        1    V(V)

Fig 9

I  2

1

0

C6

C7

0      1000      2000      3000    t(ps)

Fig 10

Fig 11

Fig 12

Fig 13

Fig 14

Fig 15

Fig 16

## RÉFÉRENCES CITÉES DANS LA DESCRIPTION

**Documents brevets cités dans la description**

• EP 0470780 A

• US 5329210 A

**Littérature non-brevet citée dans la description**

• **E.F. SCHUBERT ; N.E.J. HUNT ; R.J. MALIK ; M.MICOVIC ; D. L. MILLER.** *Journal of Lightwave Technology,* 1996, vol. 14 (7